# EUROPEAN PATENT SPECIFICATION

(11) **EP 2 550 564 B1**
(45) Date of publication and mention of the grant of the patent: **04.03.2015**
(21) Application number: 11714925.2
(22) Date of filing: 16.03.2011
(51) Int. Cl.: G03F 7/20

(54) **A BEAM LINE FOR A SOURCE OF EXTREME ULTRAVIOLET (EUV) RADIATION**
STRAHLLINIE FÜR EINE EUV-STRAHLUNGSQUELLE
LIGNE DE FAISCEAU DESTINÉE À UNE SOURCE D'ULTRAVIOLET EXTRÊME (UVE)

(30) Priority: 08.09.2010 EP 10009339; 25.03.2010 EP 10003197
(43) Date of publication of application: 30.01.2013
(73) Proprietor: ETH Zurich, 8092 Zurich (CH)
(72) Inventor: ABHARI Reza, CH-8127 Forch/ZH (CH); GIOVANNINI Andrea, CH-6900 Lugano/TI (CH); DIETERICH, Franz, CH-8957 Zurich/ZH (CH)
(74) Representative: Rentsch Partner AG
(86) International application number: PCT/EP2011/001303
(87) International publication number: WO 2011/116897

(56) References cited:
- US-A- 5 898 522
- US-A1- 2009 272 919
- US-A1- 2009 314 967

## Description

### BACKGROUND OF THE INVENTION

The present invention relates to the generation of extreme ultraviolet radiation. It refers to a beam line for a source of extreme ultraviolet (EUV) radiation.

### PRIOR ART

The next generation of semiconductor devices will be manufactured using extreme ultraviolet (EUV) lithography. EUV light is electromagnetic radiation with wavelengths between 120 nm and 10 nm. In EUV sources, a EUV-emitting plasma is produced by irradiating a target material, e.g., tin (Sn). The radiation exciting the target material can be a laser beam, thus producing a laser produced plasma (LPP). The EUV radiation is collected by a collector optic, e.g., a collimating mirror, and directed to an intermediate region for utilization outside of the EUV light source. Configurations of such EUV sources are shown in documents WO 2006/091948(A1) or WO 2009/025557(A1) or WO 2010/017892(A1), for example.

Document US2009/0314967 A1 discloses an extreme ultraviolet light source apparatus using a spectrum purity filter capable of obtaining EUV light with high spectrum purity. The apparatus includes a chamber; a target supply unit for supplying a target material; a driver laser using a laser gas containing a carbon dioxide gas as a laser medium, for applying a laser beam to the target material to generate plasma; a collector mirror for collecting and outputting the extreme ultraviolet light radiated from the plasma; and a spectrum purity filter provided in an optical path of the extreme ultraviolet light, for transmitting the extreme ultraviolet light and reflecting the laser beam, the spectrum purity filter including a mesh having electrical conductivity and formed with an arrangement of apertures having a pitch not larger than a half of a shortest wavelength of the laser beam applied by the driver laser.

The problems addressed by the patent and caused by the plasma and debris generation are the following: The focusing lens gets hot and dirty; this can cause the breaking of the lens. The laser beam that is not absorbed by the targets has to be dumped, in a way that doesn't influence the EUV beam. The connection between the source chamber and the next chamber has to be such that the EUV can go through without any additional absorption, but no particles should go in the next chamber. The contamination has to be avoided.

### SUMMARY OF THE INVENTION

It is an object of the present invention to create a beam line for a source of extreme ultraviolet (EUV) radiation to manage the light beams in the source chamber in a safe and controllable manner.

This object is obtained by a beam line according to claim 1, which comprises within a vacuum chamber a beam delivery system comprising a focusing lens and means for cooling and shielding said focusing lens; said cooling and shielding means comprising means (10, 11) for guiding a cooling gas (17) towards said focusing lens (8), where it impinges onto the outer surface of said lens (8) and escapes to the atmosphere; a EUV mirror collector, which collects and focuses the radiated EUV in a EUV beam at an intermediate focus; a beam dump capable of damping at least a portion of the laser beam without imposing a shadow on the collected and focused EUV beam; and being used as a support for radiation-sensitive sensors; and an intermediate focus module for blocking particles from leaving the vacuum chamber with the EUV beam.

The laser beam is brought in the chamber by the light delivery system and it is focused. The radiation that is not used is then absorbed in the beam dump. The EUV that is produced thanks to the focalized laser beam is collected by an ellipsoidal mirror, and is focused in its intermediate focus. The EUV beam in the intermediate focus enters then a module that separates the source vacuum chamber from the next stage, letting the radiation going through without a noticeable increase in the EUV absorption. The intermediate focus module is designed so that the gas in the main chamber cannot enter in the next stage.

An embodiment of the invention is characterized in that the focusing lens is cooled by a fluid supplied from outside the vacuum chamber.

According to another embodiment of the invention the focusing lens is shielded from debris by a gas ejected from the outer border of the focusing lens and directed along the inner surface of the focusing lens.

According to another embodiment of the invention the focusing lens is cleaned by a gas ejected from the outer border of the focusing lens and directed along the inner surface of the focusing lens.

According to another embodiment of the invention the gas ejected from the outer border of the focusing lens is being selected from the group containing hydrogen, helium, argon, neon, krypton, xenon, chlorine, fluorine, bromine, and iodine.

According to another embodiment of the gas is a mixture of a plurality of those gases, and/or the gas is ionized.

According to another embodiment of the invention the beam dump is cooled by a fluid, and that the cooling fluid passes through an internal cooling channel provided in a beam dump casing.

According to another embodiment of the invention at least two pipes are connected to the beam dump to assure flow inlet and outlet and hold the beam dump in position.

According to another embodiment of the invention radiation- and/or plasma-sensitive sensors are mounted on a side of the beam dump facing the plasma. According to another embodiment of the invention the beam dump comprises at least one cone for receiving the laser beam, whereby sensor electronics is stored and protected against radiation in a sensor space behind the at least one cone.

According to another embodiment of the invention the sensors are used for alignment, triggering, and monitoring of the plasma, radiation, and clouding.

According to another embodiment of the invention two cones made of different material are provided within the beam dump, whereby a first cone is made of a high thermal conductive material, and a second cone is placed within the first one and is made of a material with a high melting point.

According to another embodiment of the invention the cooling fluid is selected from a group containing water or oil.

According to another embodiment of the invention the intermediate focus module is shielded from debris and suspended particles by a gas ejection.

According to another embodiment of the invention the intermediate focus module comprises at least three sub chambers, whereby the sub chambers are arranged one within the other as an outer sub chamber, an intermediate sub chamber and an inner sub chamber.

According to another embodiment of the invention a gas is ejected between the outer sub chamber and the intermediate sub chamber, such that it flows primarily in direction of the vacuum chamber.

According to another embodiment of the invention all sub chambers comprise a central hole, and that the hole of the intermediate sub chamber is smaller than the hole of the outer sub chamber.

According to another embodiment of the invention the hole of the intermediate sub chamber can be adjusted along the direction of the EUV beam.

According to another embodiment of the invention the pressure in a space between outer sub chamber and the intermediate sub chamber is higher than the pressure in the vacuum chamber outside of the intermediate focus module, and is higher than the pressure in the space between the intermediate sub chamber and the inner sub chamber), and the pressure in an interface within the inner sub chamber, while the pressure in the space between the inner sub chamber and the intermediate sub chamber is lower than the pressure in the interface within the inner sub chamber.

According to another embodiment of the invention the position of the intermediate focus module can be adjusted, in order to have the focus of the radiation centred within the sub chambers.

According to another embodiment of the invention a, preferably cooled, spectral purity filter is added in the interface within the inner sub chamber, in order to let pass just the radiation of interest.

According to another embodiment of the invention the gas is selected from a group containing hydrogen, helium, argon, neon, krypton, xenon, chlorine, fluorine, bromine, and iodine.

According to another embodiment of the invention the gas is a mixture of a plurality of those gases, and/or the gas is ionized.

According to another embodiment of the invention the EUV mirror collector is part of a beam deflecting system, which comprises at least a focusing mirror, which focuses the deflected radiation in the EUV beam at the intermediate focus. According to another embodiment of the invention an additional planar deflecting mirror is provided, which deflects a small part of the generated EUV radiation onto the focusing mirror.

According to another embodiment of the invention the beam deflecting system is placed in an enclosure, which is provided with a beam entrance port for the incoming EUV radiation and a beam exit port for releasing the focused EUV beam on its way to the intermediate focus module.

According to another embodiment of the invention the enclosure comprises a first mirror container enclosing the first deflecting mirror, in the distance from the said first mirror container a second mirror container enclosing the second focusing mirror, and a connecting tube for connecting the two mirror containers, such that the EUV beam running from the first mirror to the second mirror and the focused EUV beam running from the second mirror to the beam exit port are enclosed by said connecting tube.

According to another embodiment of the invention the enclosure is mounted on an adjusting plate, which can be rotated in a plane parallel to the plane of the deflected EUV beam.

According to another embodiment of the invention the pressure within the enclosure is higher than the pressure in the surrounding vacuum chamber, such that debris is prevented from entering the beam entrance port of the enclosure.

According to just another embodiment of the invention the focused EUV beam leaves the vacuum chamber in the direction, which is essentially opposite to the direction of the entering laser beam.

According to another embodiment of the invention a higher pressure in the enclosure is achieved by means of at least one gas ejector, which directs ejected gas onto the mirror facing the plasma.

According to another embodiment of the invention the enclosure is provided with a beam entrance part, which is preferably exchangeable, and the hole area and the flow ejection direction of which can preferably be varied.

### BRIEF DESCRIPTION OF THE DRAWINGS

The present invention is now to be explained more closely by means of different embodiments and with reference to the attached drawings.
- Fig. 1: shows a first embodiment of the beam line according to the invention and its components;
- Fig. 2: shows an embodiment of the beam delivery system of Fig. 1 around the focusing lens;
- Fig. 3: shows where the laser enters the beam delivery system of Fig. 2;
- Fig. 4: shows an embodiment of the beam dump of Fig. 1;
- Fig. 5: shows an embodiment of the intermediate focus module of Fig. 1;
- Fig. 6: shows in the top view a second embodiment of the beam line according to the invention with a two-mirror configuration;
- Fig. 7: shows the main components the embodiment according to Fig. 6 in a perspective view; and
- Fig. 8: shows in the top view a third embodiment of the beam line according to the invention with only one small deflecting and focusing mirror.

### DETAILED DESCRIPTION OF DIFFERENT EMBODIMENTS OF THE INVENTION

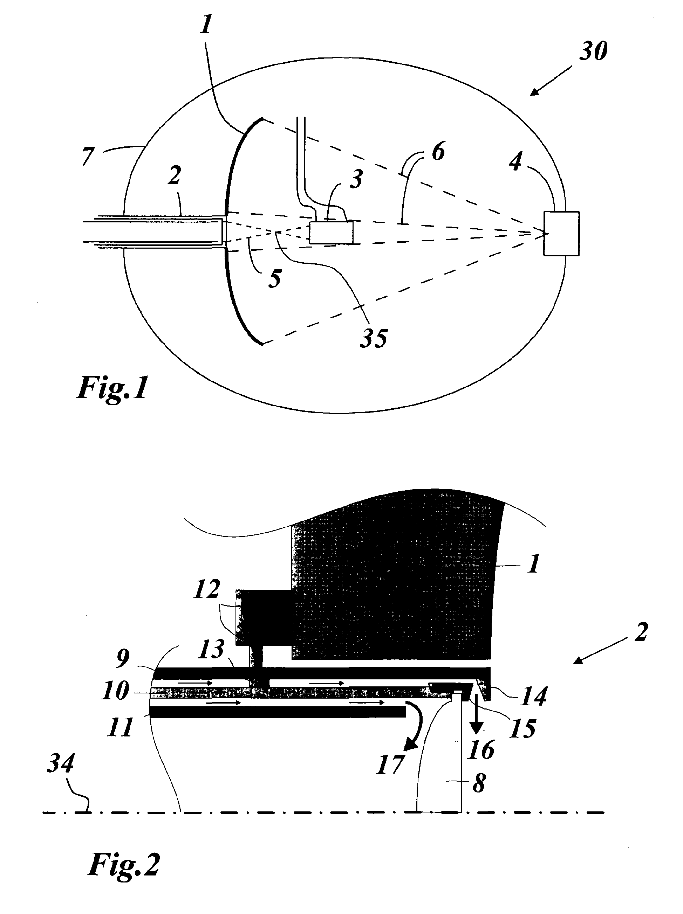

The beam line 30 according to Fig. 1 comprises at least four elements arranged in a vacuum chamber 7: a laser beam delivery system 2, a laser beam dump 3, a EUV collector mirror 1 with an ellipsoidal shape in operation, and an intermediate focus module 4. Not shown in Fig. 1 is a device for generating droplets of a liquid, e.g. molten Sn, which are ejected to a reach plasma generation point 35, where they are turned into plasma by means of a focused laser beam 5.

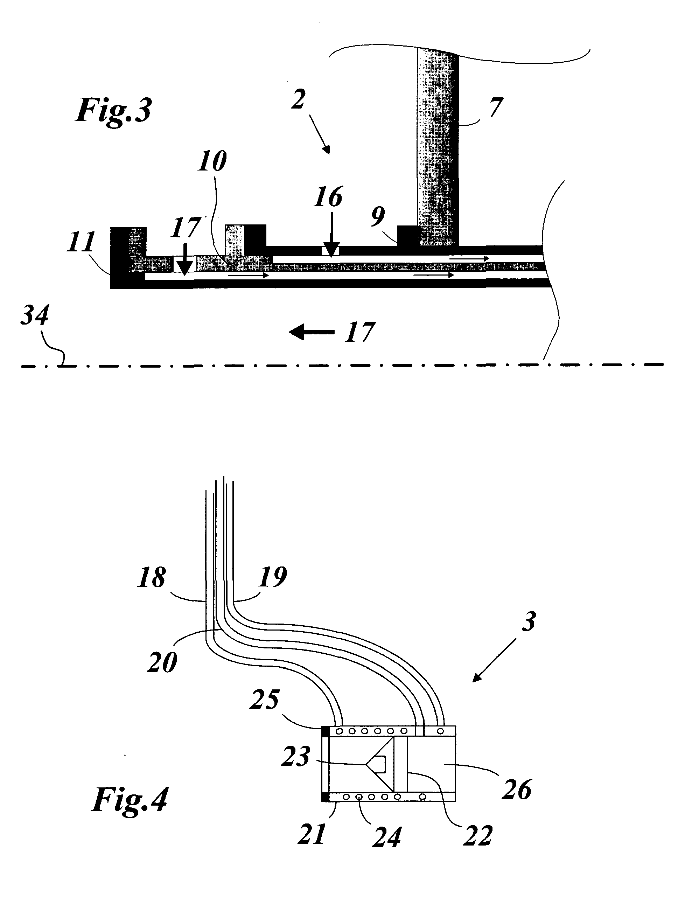

The beam delivery system 2 shown in Fig. 2 and 3 is designed to place a focusing lens 8 close to the plasma generation point 35, in order to minimize the spot size dimension (minimize the diffraction) at an intermediate focus located at the intermediate focus module 4.

The beam delivery system 2 comprises a plurality of concentric tubes, i.e. an outer tube 9, an intermediate tube 10, and an inner tube 11, which reach from the wall of the vacuum chamber 7 to the location of the laser focusing lens 8. The focusing lens 8 is positioned on the axis 34 of the EUV mirror collector 1. A collimated laser beam 5 enters the assembly through the inner tube 11 and is focused to the primary focus (at the plasma generation point 35) of the system by the focusing lens 8. The focusing lens 8 is mounted on the front of the intermediate tube 10 and held in position by a threaded ring 15.

Between the outer tube 9 and the lens carrying intermediate tube 10 a concentric duct is established, which allows a gas suitable for a mitigation of the plasma-induced debris to flow to the front of the focusing lens 8, where it is ejected radially through a convergent-divergent planar nozzle (14,15) into the vacuum chamber 7 to build up a lens gas curtain 16 (Fig. 2). This enables the flow to achieve supersonic velocity. The nozzle is shaped by the threaded ring 15 and by another ring 14 attached to the outer tube 9. The inner tube 11 guides a cooling gas 17 between itself and the lens carrying intermediate tube 10 towards the focusing lens 8. There the cooling gas 17 impinges onto the lens 8 and escapes through the inner tube 11 to the atmosphere (Fig. 2).

Positioning devices 12, which are fixed to the vacuum chamber 1 (collector casing) and push the concentric tubes 9, 10 and 11 in radial direction, allow a micropositioning of the focusing lens 8 on the axis 34 of the EUV mirror collector 1. Distance pieces 13 between the outer tube 9 and the lens carrying intermediate tube 10 transfer this radial motion to the lens 8.

The lens gas curtain 16 for debris mitigation and the cooling gas 17 are injected in between the concentric tubes 9, 10 and 11 at the outside of the vacuum chamber 7 (see Fig. 3). The lens carrying intermediate tube 10 and the threaded ring 15, which holds the lens 8 in place, are designed to withstand the pressure difference between atmosphere and the vacuum. The lens gas curtain 16 can be also used as a cleaning means for the inner lens surface, using a cleaning gas or a mixture of the debris mitigation gas (preferably Argon) and the cleaning gas.

The laser beam 5, after being focused by the beam delivery system 2, irradiates the droplets mentioned before. However, not all of each laser pulse and not every pulse are assumed to be absorbed by the droplets. The part of the laser beam 5 that is not absorbed, continues in his path, diverges, and enters the beam dump 3.

The beam dump 3 (Fig. 4) is designed to sustain a power up to 2kW of absorbed radiation in vacuum, i.e. without the help of natural convection. In the preferred embodiment the beam dump 3 is located in the region, where the EUV beam 6 of collected and reflected EUV radiation doesn't pass. This constrains the dimension and the position of the beam dump 3 in the vacuum chamber 7. A suitable fluid cools the beam dump 3 and passes through an internal cooling channel 24 provided in the wall of the cylindrical beam dump casing 21. The internal cooling channel 24 has a spiral shape and is designed taking into account the pressure drop of the cooling fluid and the total surface area necessary to get the needed heat transfer. The temperature increase of the cooling fluid is designed to be less than 10°C for a received power up to 2kW. In order to minimize the shadowing of the EUV beam 6 by the beam dump 3, the beam dump 3 is held in position by a plurality of pipes 18, 19 and 20, which supply and remove the coolant. For the same reason, these pipes, the cooling inlet pipe 18, the cooling outlet pipe 19, and the pipe 20 for the electrical cables are arranged one behind the other in the axial direction.

In the cooled cylindrical beam dump casing 21 a beam dump cone 22, 23 is installed to reflect and absorb the remains of the laser beam 5. The contact area between the cylindrical beam dump casing 21 and the beam dump cone 22, 23 is maximized in order to maximize the heat removed from the cone. The beam dump cone 22, 23 is made out of two different materials: one is used for the outer part (cone 22) in order to optimize heat conduction, while for the tip (cone 23) another material is used in order to maximize the melting point. In a preferred embodiment the material for the outer cone 22 is Aluminium, and the material for the inner cone 23 is Nickel.

On the lip of the cooled cylindrical beam dump casing 21 that faces the plasma, radiation- and/or plasma-sensitive sensors 25 can be mounted. The sensors 25, which are directly cooled, are used for controlling the alignment of the droplets with the beam line and synchronizing of the moving droplets and the laser pulses. Furthermore, the sensors 25 monitor directly the radiation and/or plasma intensity and/or the presence of neutrals (clouding) without imposing a shadow in the EUV beam 6, and without being directly irradiated by the laser beam 5. Behind the cones 22, 23, another space is provided, which is used as a sensor space 26. The sensor space 26 is predisposed to store sensor hardware, to protect it against the incoming laser beam 5. The electrical cable pipe 20, which opens into the sensor space 26, is used to bring the cables of the sensor arrangement out of the beam dump 3. The cooling inlet pipe 18 directly cools the electrical cable pipe 20, since these are in contact (Fig. 4). The cooling fluid can be chosen from a variety of different fluids, especially including water and oil.

In a preferred embodiment the beam dump 3 is coated with paint, without carbon, that enhances the absorption of the laser light. In another embodiment no coating is used, so that the chamber and the collector are not contaminated.

The EUV beam 6, after reflection from the multilayer EUV mirror collector 1, is focused to give the intermediate focus of the ellipsoidal collector mirror. At the intermediate focus (IF) the intermediate focus module 4 is integrated in order to prevent ions and neutrals to enter the next stage (not shown in Fig. 1), which is situated at the exit of the beam line 30 to receive and use the EUV radiation. The intermediate focus module 4 can be moved to be centred with respect to the EUV beam 6. In order to shield the intermediate focus module 4, a gas flow is used.

The intermediate focus module 4 comprises three sub chambers 27, 28 and 29, which are contained one within the other, and are each provided with a central opening or hole. A gas is injected between the outer sub chamber 27 and the intermediate sub chamber 28, and is ejected mainly into the vacuum chamber 7. In order to minimize the amount of gas that flows in the space 32 between the intermediate sub chamber 28 and the inner sub chamber 29, the hole in the intermediate sub chamber 28 is smaller than the hole in the outer sub chamber 27. In order to have the hole in the intermediate sub chamber 28 as small as possible, in a preferred embodiment the hole is placed just in the position of the intermediate focus IF. The small amount of gas that goes through the hole in the intermediate sub chamber 28 is then sucked away between the intermediate sub chamber 28 and the inner sub chamber 29, where the pressure is the lowest in the system. This pressure is also smaller compared with the pressure inside the inner sub chamber 29, where there is the interface 33 with the next stage. This leads to a small flux that exits the inner sub chamber 29, and thus prevents any particles to enter.

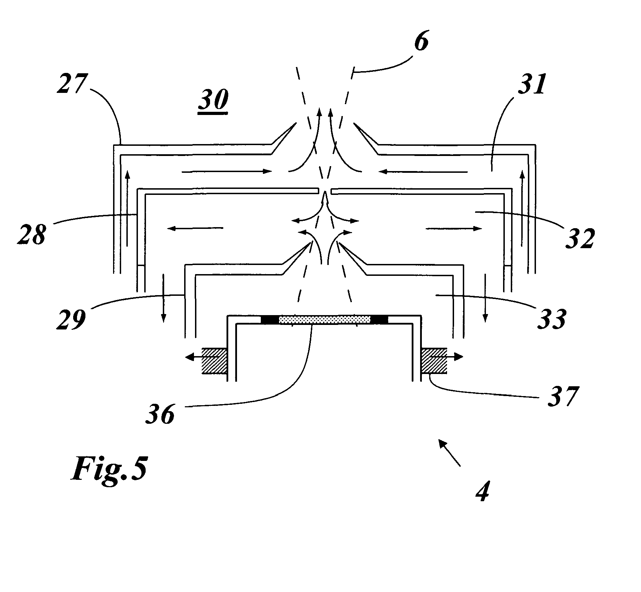

The pressures in the spaces 31, 32 and 33 between the sub chambers should be chosen as follows: the pressure in space 31 is higher than the pressure in the vacuum chamber 30 and the space 32; the pressure in space 32 is lower than the pressure in the interface 33, space 31, and the vacuum chamber 7. The pressure in the interface 33 is generally lower than the pressure in the vacuum chamber 7. But in another embodiment it can be also the opposite. This configuration permits to have a flow circulating as represented in Fig. 5 that blocks particles going from the vacuum chamber 7 to the next stage.

In a preferred embodiment the order of magnitude of the values for the pressure can be chosen as follows: in the vacuum chamber 7: 0.1 mbar; in space 31: 1 mbar; in space 32: 10⁻⁶mbar or lower, if a pressure lower than 10⁻⁶mbar is required in the interface 33. In the interface 33 the pressure value depends on the next stage, and is for example 10⁻⁴mbar. In the EUV path the pressure remains high just for a minimum length; therefore the intermediate focus module 4 doesn't noticeably increase the EUV absorption.

The position of the central hole of the intermediate sub chamber 28 can be controlled. In another embodiment, the position of this hole is moved to a place after the intermediate focus IF, and the hole has a larger diameter, large enough to let the diverging EUV radiation go through.

In the interface 33, clean from contamination, a spectral purity filter 36 can be placed. The spectral purity filter is directly cooled, where a cooling means 37 works through conduction on the side and/or through convection on the surface. In a preferred embodiment the spectral purity filter comprises a Zr film.

The gas used for the intermediate focus module 4 and for the lens debris mitigation is chosen from a variety of different gases, in neutral or ionic state, including: hydrogen, helium, argon, neon, krypton, xenon, chlorine, fluorine, bromine, and iodine. The gas can also be a mixture of the listed gases.

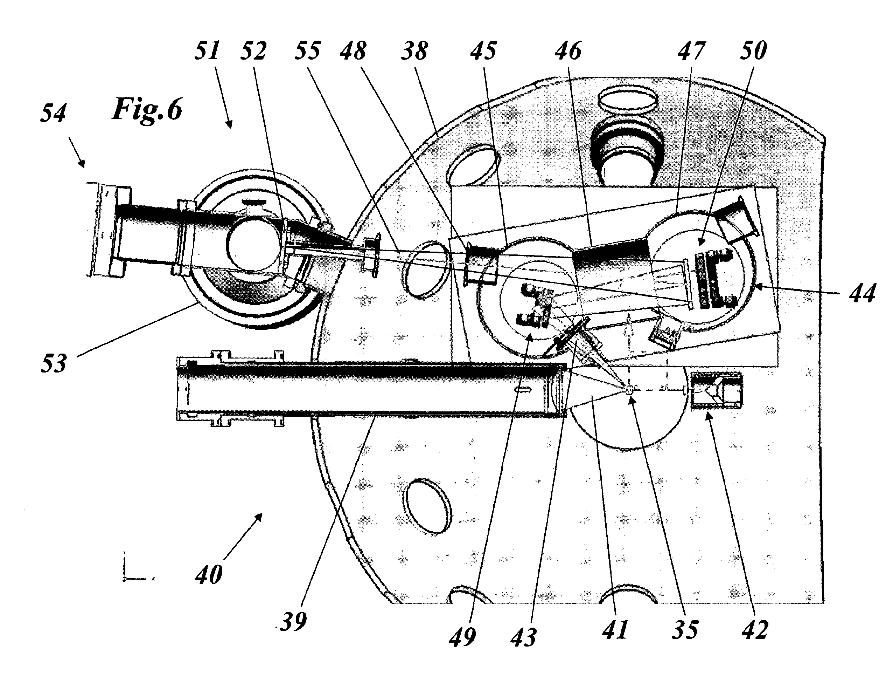

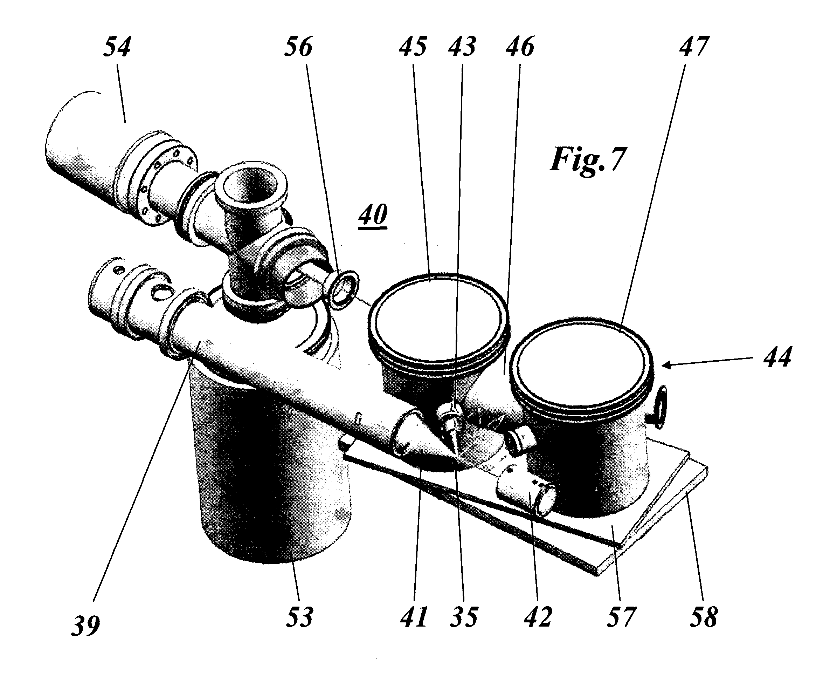

Fig. 6 and 7 show another embodiment of the beam line according to the invention. The beam line 40 shown in these figures comprises a vacuum chamber 38 in the centre of which the plasma generation point 35 is located. A beam delivery system 39 for delivering a focused laser beam 41 enters the vacuum chamber, such that the laser beam is focused at the plasma generation point 35. On the opposite is side of the beam delivery system 39 the beam dump 42 is placed, which is similar to that shown in Fig. 4.

Different from the arrangement shown in Fig. 1 the EUV radiation emanating from the plasma generation point 35 is not collected and focused by means of a big elliptical mirror. Only a small part of this radiation enters the beam deflecting system 44 through the relatively smart opening of a beam entrance port 43. The beam entrance port 43 is the beam entrance of an enclosure 45, 46 and 47, which contains the beam deflecting system 44. This beam deflecting system 44 comprises a relatively small first mirror 49, which is designed as a planar deflecting mirror. This deflecting mirror 49 deflects the radiation entering the beam entrance port 43 on to the second focusing mirror 50, which is arranged at a distance from the first mirror 49. The focusing mirror 50 focuses the EUV radiation coming from the first mirror 49 into a focused EUV beam 55, which has its focal point at an aperture 52 within an intermediate focus module 51. The focus beam leaves the enclosure 45, 46 and 47 through a beam exit port 48. A guiding tube 56 at the entrance of the intermediate focus module 51 helps to screen any debris from entering the module. Between the aperture 52 and a beam outlet section 54 of the intermediate focus module 51 a vacuum pump is placed for differential pressure purposes.

The enclosure for the beam deflecting system 44 is necessary to keep a pressure inside, which is a little bit higher than in the surrounding vacuum chamber 38, so that a suitable gas as specified before can flow from inside the enclosure through the beam entrance port 43 into the vacuum chamber 38 to protect the first mirror 49 against the degrading effects of the debris.

The enclosure has a simple and stable construction, and it is designed to give easy access to the mirrors 49 and 50, so that the mirrors can be easily adjusted or replaced in case of damage. The enclosure comprises a first cylindrical mirror container 45 containing the first mirror 49, and a second cylindrical mirror container 47 containing the second mirror 50. Both containers 45 and 47 are connected by a cylindrical connecting to 46. The connecting tube 46 is designed such that the EUV beam running from the first mirror 49 to the second mirror 50 and the focused EUV beam 55 running from the second mirror 50 to the beam exit port 48 are enclosed by said connecting tube 46. The enclosure is placed on an adjusting plate 57, which is repeatedly supported by a fixed base plate 58 such that it can be rotated in a plane parallel to the plane of the deflected EUV beam 55.

The containers 45 and 47 of the enclosure are each closed by a detachable lid, so that there is an easy access to the mirrors inside.

Due to the special beam forming system of the second embodiment the resulting EUV source has a high brightness instead of a high power. Thus, the characteristics and advantages of this embodiment are:
- The brightness of the source is optimized, which is required for metrology tools.
- The cost of the one or two multilayer (ML) mirrors 49 and 50 is much lower than the big elliptical ML mirror (factor greater than 10).
- The debris mitigation is directed just to a smaller (not more than 40 mm) diameter optic, instead of 250 mm. The debris mitigation is much more concentrated, and is therefore larger.
- In the two mirrors configuration the first mirror 49 is a small planar ML. If the debris mitigation doesn't stop the more energetic ions, this mirror could be replaced as consumable, in order to avoid a long-term loss in reflectivity.
- The gas used for debris mitigation can be chosen to have a cleaning effect.
- The intermediate focus module 51 is so designed that a contamination is avoided with differential pumping.

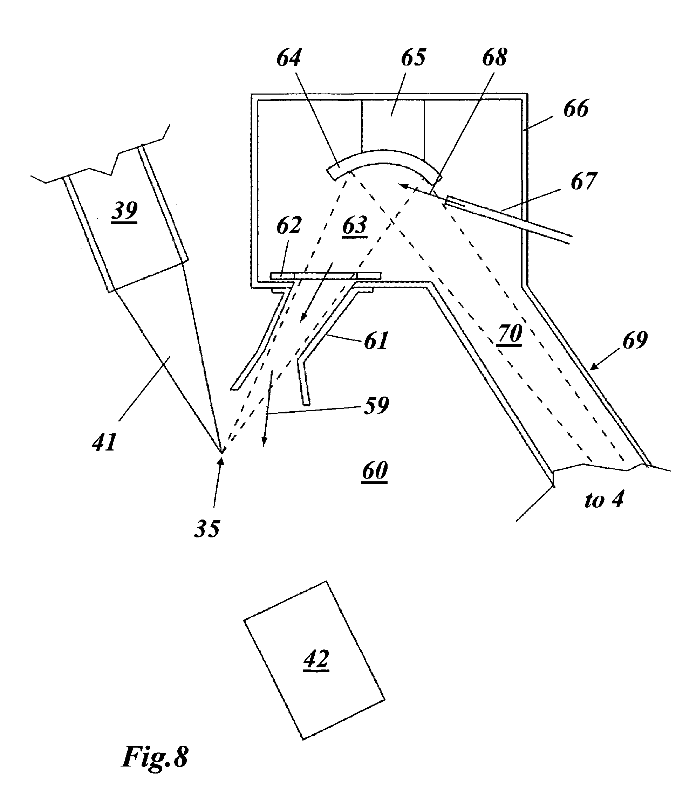

Fig. 8 shows another embodiment of the beam line according to the invention. In the beam line 60 shown in this figure the components are located again in a vacuum chamber (not shown) in the centre of which the plasma generation point 35 is located. A beam delivery system 39 for delivering a focused laser beam 41 enters the vacuum chamber, such that the laser beam 41 is focused at the plasma generation point 35. On the opposite is side of the beam delivery system 39 the beam dump 42 is placed, which is similar to that shown in Fig. 4.

Different from the arrangement shown in Fig. 1 the EUV radiation emanating from the plasma generation point 35 is not collected and focused by means of a big elliptical mirror. Only a small part of this radiation enters the beam deflecting system through the relatively small opening of a beam entrance part 61. The beam entrance part 61 is the beam entrance of an enclosure 66, which contains the beam deflecting system. This beam deflecting system comprises a mirror 64 on a mirror holder 65, which mirror 64 is designed as to reflect and focus the EUV beam 63, 70. The focal point of the EUV beam is at an aperture as shown in Fig. 5 of the subchamber 28 within an intermediate focus module 4. The focus beam is enclosed in the enclosure 66 up to the intermediate focus module 4. The subchamber 27 in Fig. 5 is substituted by the enclosure 66 in Fig. 8.

The enclosure 66 for the beam deflecting system is necessary to keep a pressure inside, which is higher than in the surrounding vacuum chamber, so that a suitable stream of gas as specified before can flow from inside the enclosure 66 through the beam entrance port 61 into the surrounding vacuum chamber to protect the mirror 64 against the degrading effects of the debris.

At the exit of the enclosure 66 the flow is choked, which leads to a locally larger density. The converging part of the beam entrance part 61 that ends with the ejection hole can be exchangeable. One configuration of the converging-diverging part 61 is to have an ejection in the direction of the plasma; another one is to have the hole with an elliptical shape, so that the flow is directed with an angle. A gas ejector 67 enters the enclosure 66 and directs ejected gas 68 onto the mirror 64.

A shutter 62 may be implemented in the system to be able to protect the mirror in case of problems.

### LIST OF REFERENCE NUMERALS

- 1: EUV mirror collector
- 2: beam delivery system
- 3: beam dump
- 4: intermediate focus module
- 5: laser beam
- 6: EUV beam
- 7: vacuum chamber
- 8: focusing lens
- 9: outer tube
- 10: intermediate tube
- 11: inner tube
- 12: positioning device
- 13: distance pieces
- 14,15: ring
- 16: lens gas curtain
- 17: cooling gas
- 18: cooling inlet pipe
- 19: cooling outlet pipe
- 20: electrical cable pipe
- 21: cylindrical beam dump casing
- 22,23: beam dump cone
- 24: internal cooling channel
- 25: sensor (radiation- and/or plasma sensitive)
- 26: sensor space
- 27: outer sub chamber
- 28: intermediate sub chamber
- 29: inner sub chamber
- 30: beam line
- 31: space (between outer and intermediate sub chambers)
- 32: space (between intermediate and inner sub chambers)
- 33: interface (between IF module and module after the source)
- 34: axis of rotation
- 35: plasma generation point
- 36: spectral purity filter
- 37: cooling means
- 38: vacuum chamber
- 39: beam delivery system
- 40,60: beam line
- 41: laser beam
- 42: beam dump
- 43: beam entrance port
- 44: beam deflecting system
- 45,47: mirror container
- 46: connecting tube
- 48: beam exit port
- 49: deflecting mirror
- 50: focusing mirror
- 51: intermediate focus module
- 52: aperture
- 53: vacuum pump
- 54: beam outlet section
- 55,63,70: EUV beam
- 56: guiding tube
- 57: adjusting plate
- 58: base plate
- 59,68: ejected gas
- 61: beam entrance part
- 62: shutter
- 64: mirror
- 65: mirror holder
- 66: beam delivery enclosure
- 67: gas ejector
- 69: connection to IF module (closed)

## Claims

1. A beam line (30, 40, 60) for a source of extreme ultraviolet (EUV) radiation, wherein a EUV-radiating plasma is generated by irradiating droplets of a suitable target material with a focused laser beam (5, 41) at a plasma generation point (35), said beam line (30, 40, 60) comprising within a vacuum chamber (7, 38):
a beam delivery system (2, 39) comprising a focusing lens (8) and means (9, 10, 11, 13, 14, 15) for cooling and shielding said focusing lens (8); said cooling and shielding means comprising means (10, 11) for guiding a cooling gas (17) towards said focusing lens (8), where it impinges onto the outer surface of said lens (8) and escapes to the atmosphere;
a EUV mirror collector (1, 50, 64), which collects and focuses the radiated EUV in a EUV beam (6, 55, 63, 70) at an intermediate focus (IF);
a beam dump (3, 42) capable of damping at least a portion of the laser beam (5, 41) without imposing a shadow on the collected and focused EUV beam (6, 55, 63, 70); and
an intermediate focus module (4, 51) for blocking particles and/or radiation from leaving the vacuum chamber (7, 38) with the EUV beam (6, 55, 63, 70).

2. A beam line according to claim 1, **characterized in that** the focusing lens (8) is cooled by a fluid supplied from outside the vacuum chamber (7).

3. A beam line according to claim 1 or 2, **characterized in that** the focusing lens (8) is shielded from debris by a gas ejected from the outer border of the focusing lens (8) and directed along the inner surface of the focusing lens (8).

4. A beam line according to one of the claims 1 to 3, **characterized in that** the focusing lens (8) is cleaned by a gas ejected from the outer border of the focusing lens (8) and directed along the inner surface of the focusing lens (8).

5. A beam line according to claim 3 or 4, **characterized in that** the gas ejected from the outer border of the focusing lens (8) is being selected from the group containing hydrogen, helium, argon, neon, krypton, xenon, chlorine, fluorine, bromine, and iodine.

6. A beam line according to claim 5, **characterized in that** the gas is a mixture of a plurality of those gases, and/or the gas is ionized.

7. A beam line according to claim 1, **characterized in that** the beam dump (3) is cooled by a fluid, that the cooling fluid passes through an internal cooling channel (24) provided in a beam dump casing (21), and that at least two pipes (18, 19) are connected to the beam dump (3) to assure flow inlet and outlet and hold the beam dump (3) in position.

8. A beam line according to claim 1, **characterized in that** radiation- and/ or plasma sensitive sensors (25) are mounted on a side of the beam dump (3) facing the plasma, that the beam dump (3) comprises at least one cone (22, 23) for receiving the laser beam (5), and that sensor electronics is stored and protected against radiation in a sensor space (26) behind the at least one cone (22, 23).

9. A beam line according to claim 8, **characterized in that** the sensors (25) are used for alignment, triggering, and monitoring of the plasma, radiation, and clouding.

10. A beam line according to claim 8, **characterized in that** two cones (22, 23) made of different material are provided within the beam dump (3), whereby a first cone (22) is made of a high thermal conductive material, and a second cone (23) is placed within the first one (22) and is made of a material with a high melting point.

11. A beam line according to claim 7, **characterized in that** the cooling fluid is selected from a group containing water or oil.

12. A beam line according to claim 1, **characterized in that** the intermediate focus module (4) is shielded from debris and suspended particles by a gas ejection.

13. A beam line according to claim 1, **characterized in that** the intermediate focus module (4) comprises at least three sub chambers (27, 28, 29), that the sub chambers (27, 28, 29) are arranged one within the other as an outer sub chamber (27), an intermediate sub chamber (28) and an inner sub chamber (29), and that a gas is ejected between the outer sub chamber (27) and the intermediate sub chamber (28), such that it flows primarily in direction of the vacuum chamber (7).

14. A beam line according to claim 13, **characterized in that** all sub chambers (27, 28, 29) comprise a central hole, that the hole of the intermediate sub chamber (28) is smaller than the hole of the outer sub chamber (27), and that the hole of the intermediate sub chamber (28) can be adjusted along the direction of the EUV beam (6).

15. A beam line according to claim 13 or 14, **characterized in that** the pressure in a space (31) between outer sub chamber (27) and the intermediate sub chamber (28) is higher than the pressure in the vacuum chamber (7) outside of the intermediate focus module (4), and is higher than the pressure in the space (32) between the intermediate sub chamber (28) and the inner sub chamber (29), and the pressure in an interface (33) within the inner sub chamber (29), while the pressure in the space (32) between the inner sub chamber (29) and the intermediate sub chamber (28) is lower than the pressure in the interface (33) within the inner sub chamber (29).

16. A beam line according to claim 13, **characterized in that** the position of the intermediate focus module (4) can be adjusted, in order to have the focus of the radiation centred within the sub chambers (27, 28, 29).

17. A beam line according to claim 13, **characterized in that** a spectral purity filter (36) is added in the interface (37) within the inner sub chamber (29), and that the spectral purity filter (36) is cooled (37).

18. A beam line according to claim 13, **characterized in that** the gas is selected from a group containing hydrogen, helium, argon, neon, krypton, xenon, chlorine, fluorine, bromine, and iodine.

19. A beam line according to claim 18, **characterized in that** the gas is a mixture of a plurality of those gases, and/or the gas is ionized.

20. A beam line according to claim 1, **characterized in that** the EUV mirror collector (50, 64) is part of a beam deflecting system (44), which comprises at least a focusing mirror (50, 64), which focuses the deflected radiation in the EUV beam (55, 70) at the intermediate focus (IF), and that an additional planar deflecting mirror (49) is provided, which deflects a small part of the generated EUV radiation onto the focusing mirror (50).

21. A beam line according to claim 20, **characterised in that** the beam deflecting system (44) is placed in an enclosure (45, 46, 47; 66), which is provided with a beam entrance port (43, 61) for the incoming EUV radiation and a beam exit port (48) for releasing the focused EUV beam (55, 70) on its way to the intermediate focus module (51), that the enclosure (45, 46, 47) comprises a first mirror container (45) enclosing the first deflecting mirror (49), in the distance from the said first mirror container (45) a second mirror container (47) enclosing the second focusing mirror (50), and a connecting tube (46) for connecting the two mirror containers (45, 47), such that the EUV beam running from the first mirror (49) to the second mirror (50) and the focused EUV beam running from the second mirror (50) to the beam exit port (48) are enclosed by said connecting tube (46).

22. A beam line according to claim 21, **characterised in that** the enclosure (45, 46, 47) is mounted on an adjusting plate (57), which can be rotated in a plane parallel to the plane of the deflected EUV beam (55).

23. A beam line according to claim 21 or 22, **characterised in that** the pressure within the enclosure (45, 46, 47) is higher than the pressure in the surrounding vacuum chamber (38), such that debris is prevented from entering the beam entrance port (43) of the enclosure (45, 46, 47).

24. A beam line according to one of the claims 21 to 23, **characterised in that** the focused EUV beam (55) leaves the vacuum chamber (38) in the direction, which is essentially opposite to the direction of the entering laser beam (41).

25. A beam line according to one of the claims 21 to 24, **characterized in that** a higher pressure in the enclosure (45, 46, 47; 66) is achieved by means of at least one gas ejector (67), which directs ejected gas (68) onto the mirror (49, 64) facing the plasma.

26. A beam line according to one of the claims 21 to 25, **characterized in that** the enclosure (66) is provided with a beam entrance part (61), which is preferably exchangeable, and the hole area and the flow ejection direction of which can preferably be varied.

## Patentansprüche

1. Strahlführung (30, 40, 60) für eine Quelle Extrem Ultravioletter (EUV) Strahlung, wobei ein EUV-strahlendes Plasma durch Bestrahlen von Tröpfchen eines geeigneten Target-Materials mit einem fokussierten Laserstrahl (5, 41) an einem Plasmaerzeugungspunkt (35) erzeugt wird, wobei die Strahlführung (30, 40, 60) in einer Vakuumkammer (7, 38) Folgendes umfasst:
ein Strahlbereitstellungssystem (2, 39), das eine Fokussierlinse (8) und Vorrichtungen (9, 10, 11, 13, 14, 15) zum Kühlen und Abschirmen der Fokussierlinse (8) umfasst; wobei die Kühl- und Abschirmvorrichtungen Vorrichtungen (10, 11) zum Leiten eines Kühlgases (17) zu der Fokussierlinse (8) umfassen, wo es auf die Außenfläche der Linse (8) trifft und in die Atmosphäre entweicht;
einen EUV-Kollektorspiegel (1, 50, 64), der das abgestrahlte EUV bei einem Zwischenfokus (intermediate focus, IF) zu einem EUV-Strahl (6, 55, 63, 70) sammelt und fokussiert;
eine Strahlfalle (3, 42), die mindestens einen Teil des Laserstrahls (5, 41) entsorgen kann, ohne den gesammelten und fokussierten EUV-Strahl (6, 55, 63, 70) zu verschatten; und
ein Zwischenfokus-Modul (4, 51), um zu verhindern, dass Partikel und/oder Strahlung die Vakuumkammer (7, 38) mit dem EUV-Strahl (6, 55, 63, 70) verlassen.

2. Strahlführung nach Anspruch 1 **dadurch gekennzeichnet, dass** die Fokussierlinse (8) mittels eines Fluids gekühlt wird, das von außerhalb der Vakuumkammer (7) gespeist wird.

3. Strahlführung nach Anspruch 1 oder 2 **dadurch gekennzeichnet, dass** die Fokussierlinse (8) gegen Ablagerungen durch ein Gas abgeschirmt wird, das von der Außengrenze der Fokussierlinse (8) ausgestoßen und entlang der Innenfläche der Fokussierlinse (8) geführt wird.

4. Strahlführung nach einem der Ansprüche 1 bis 3 **dadurch gekennzeichnet, dass** die Fokussierlinse (8) durch ein Gas gereinigt wird, das von der Außengrenze der Fokussierlinse (8) ausgestoßen und entlang der Innenfläche der Fokussierlinse (8) geführt wird.

5. Strahlführung nach Anspruch 3 oder 4 **dadurch gekennzeichnet, dass** das Gas, das von der Außengrenze der Fokussierlinse (8) ausgestoßen wird, aus der Gruppe ausgewählt ist, die Wasserstoff, Helium, Argon, Neon, Krypton, Xenon, Chlor, Fluor, Brom und Iod umfasst.

6. Strahlführung nach Anspruch 5 **dadurch gekennzeichnet, dass** das Gas eine Mischung einer Mehrzahl dieser Gase ist und/oder dass das Gas ionisiert ist.

7. Strahlführung nach Anspruch 1 **dadurch gekennzeichnet, dass** die Strahlfalle (3) mittels eines Fluids gekühlt wird, dass das Kühlfluid durch einen innen liegenden Kühlkanal (24) geführt wird, der in einem Strahlfallen-Gehäuse (21) bereitgestellt wird, und dass mindestens zwei Leitungen (18, 19) an die Strahlfalle (3) angeschlossen sind, um Ein- und Ausstrom zu gewährleisten und die Strahlfalle (3) in Position zu halten.

8. Strahlführung nach Anspruch 1 **dadurch gekennzeichnet, dass** strahlungs- und/oder plasmasensitive Sensoren (25) an einer zum Plasma weisenden Seite der Strahlfalle (3) montiert sind, dass die Strahlfalle (3) mindestens einen Konus (22, 23) zur Aufnahme des Laserstrahls (5) umfasst, und dass die Sensorelektronik in einem Sensorraum (26) hinter dem mindestens einen Konus (22, 23) angeordnet und gegen Strahlung geschützt ist.

9. Strahlführung nach Anspruch 8 **dadurch gekennzeichnet, dass** die Sensoren (25) zum Fluchten, Triggern und zur Überwachung von Plasma, Strahlung und Eintrübung verwendet werden.

10. Strahlführung nach Anspruch 8 **dadurch gekennzeichnet, dass** zwei aus verschiedenen Materialien gefertigte Konusse (22, 23) in der Strahlfalle (3) bereitgestellt werden, wobei ein erster Konus (22) aus einem Material mit hoher thermischer Leitfähigkeit gefertigt ist und ein zweiter Konus (23) in dem ersten (22) angeordnet und aus einem Material mit einem hohen Schmelzpunkt gefertigt ist.

11. Strahlführung nach Anspruch 7 **dadurch gekennzeichnet, dass** das Kühlfluid aus einer Gruppe ausgewählt ist, die Wasser und Öl enthält.

12. Strahlführung nach Anspruch 1 **dadurch gekennzeichnet, dass** das Zwischenfokus-Modul (4) gegen Ablagerungen und schwebende Partikel durch einen Gasausstoß abgeschirmt wird.

13. Strahlführung nach Anspruch 1 **dadurch gekennzeichnet, dass** das Zwischenfokus-Modul (4) mindestens drei Unterkammern (27, 28, 29) umfasst, dass die Unterkammern (27, 28, 29) ineinander als eine äußere Unterkammer (27), eine zwischengelagerte Unterkammer (28) und eine innere Unterkammer (29) angeordnet sind, und dass ein Gas zwischen der äußeren Unterkammer (27) und der zwischengelagerten Unterkammer (28) ausgestoßen wird, so dass es im Wesentlichen in Richtung der Vakuumkammer (7) strömt.

14. Strahlführung nach Anspruch 13 **dadurch gekennzeichnet, dass** alle Unterkammern (27, 28, 29) eine zentrale Bohrung umfassen, dass die Bohrung der zwischengelagerten Unterkammer (28) kleiner als die Bohrung der äußeren Unterkammer (27) ist, und dass die Bohrung der zwischengelagerten Unterkammer (28) entlang der Richtung des EUV-Strahls (6) verstellbar ist.

15. Strahlführung nach Anspruch 13 oder 14 **dadurch gekennzeichnet, dass** der Druck in einem Raum (31) zwischen äußerer Unterkammer (27) und zwischengelagerter Unterkammer (28) höher als der Druck in der Vakuumkammer (7) außerhalb des Zwischenfokus-Moduls (4) und höher als der Druck in dem Raum (32) zwischen der zwischengelagerten Unterkammer (28) und der inneren Unterkammer (29) und dem Druck in einer Schnittstelle (33) in der inneren Unterkammer (29) ist, wobei der Druck in dem Raum (32) zwischen der inneren Unterkammer (29) und der zwischengelagerten Unterkammer (28) niedriger als der Druck in der Schnittstelle (33) in der inneren Unterkammer (29) ist.

16. Strahlführung nach Anspruch 13 **dadurch gekennzeichnet, dass** die Position eines Zwischenfokus-Moduls (4) verstellbar ist, um den Fokus der Strahlung zentriert in den Unterkammern (27, 28, 29) zu erhalten.

17. Strahlführung nach Anspruch 13 **dadurch gekennzeichnet, dass** ein Spektralreinheitsfilter (36) zu der Schnittstelle (37) in der inneren Unterkammer (29) gegeben wird und dass der Spektralreinheitsfilter (36) gekühlt wird (37).

18. Strahlführung nach Anspruch 13 **dadurch gekennzeichnet, dass** das Gas aus einer Gruppe ausgewählt ist, die Wasserstoff, Helium, Argon, Neon, Krypton, Xenon, Chlor, Fluor, Brom und Iod umfasst.

19. Strahlführung nach Anspruch 18 **dadurch gekennzeichnet, dass** das Gas eine Mischung aus einer Mehrzahl von Gasen ist und/oder dass das Gas ionisiert ist.

20. Strahlführung nach Anspruch 1 **dadurch gekennzeichnet, dass** der EUV-Kollektorspiegel (50, 64) Teil eines Strahlablenksystems (44) ist, das mindestens einen Fokussierspiegel (50, 64) umfasst, der die abgelenkte Strahlung an dem Zwischenbrennpunkt (IF) in den EUV-Strahl (55, 70) fokussiert, und dass ein zusätzlicher, planarer Ablenkspiegel (49) bereitgestellt wird, der einen kleinen Teil der erzeugten EUV-Strahlung auf den Fokussierspiegel (50) ablenkt.

21. Strahlführung nach Anspruch 20 **dadurch gekennzeichnet, dass** das Strahlablenksystem (44) in einem Gehäuse (45, 46, 47) angeordnet ist, das mit einem Strahleingangsport (43, 61) für die eingehende EUV-Strahlung und einen Strahlausgangsport (48) zur Freisetzung des fokussierten EUV-Strahls (55, 70) auf seinem Weg zu dem Zwischenfokus-Modul (51) bereitgestellt wird, dass das Gehäuse (45, 46, 47) einen ersten Spiegelbehälter (45) umfasst, der einen ersten Ablenkspiegel (49) umschließt, in dem Abstand von dem ersten Spiegelbehälter (45) einen zweiten Spiegelbehälter (47), der den zweiten Fokussierspiegel (50) umschließt, und ein Verbindungsrohr (46) zum Anschluss der zwei Spiegelbehälter (45, 47), so dass der EUV-Strahl, der von dem ersten Spiegel (49) zu dem zweiten Spiegel (50) verläuft, und der fokussierte EUV-Strahl, der von dem zweiten Spiegel (50) zu dem Strahlausgangsport (48) verläuft, durch das Verbindungsrohr (46) umschlossen sind.

22. Strahlführung nach Anspruch 21 **dadurch gekennzeichnet, dass** das Gehäuse (45, 46, 47) auf einer Stellplatte (57) befestigt ist, die in einer Ebene parallel zu der Ebene des abgelenkten EUV-Strahls (55) drehbar ist.

23. Strahlführung nach Anspruch 21 oder 22 **dadurch gekennzeichnet, dass** der Druck in dem Gehäuse (45, 46, 47) höher als der Druck in der umgebenden Vakuumkammer (38) ist, so dass verhindert wird, dass Ablagerungen durch den Strahleingangsport (43) des Gehäuses (45, 46, 47) eintreten.

24. Strahlführung nach einem der Ansprüche 21 bis 23 **dadurch gekennzeichnet, dass** der fokussierte EUV-Strahl (55) die Vakuumkammer (38) in der Richtung verlässt, die im Wesentlichen entgegengesetzt zu der Richtung des eintretenden Laserstrahls (41) ist.

25. Strahlführung nach einem der Ansprüche 21 bis 24 **dadurch gekennzeichnet, dass** ein höherer Druck in dem Gehäuse (45, 46, 47; 66) durch mindestens einen Gasaustoßer (67) erzielt wird, der ausgestoßenes Gas (68) auf den dem Plasma zugewandten Spiegel (49, 64) richtet.

26. Strahlführung nach einem der Ansprüche 21 bis 25 **dadurch gekennzeichnet, dass** das Gehäuse (66) mit einem Strahleingangsteil (61) bereitgestellt wird, das vorzugsweise austauschbar ist, und wobei der Bohrungsbereich und die Ausstoßrichtung davon vorzugsweise variabel sind.

## Revendications

1. Ligne de faisceau (30, 40, 60) pour une source de rayonnement ultraviolet extrême (EUV), un plasma à rayonnement EUV étant généré par irradiation de gouttelettes d'une matière cible appropriée par un faisceau laser focalisé (5, 41) au niveau d'un point de génération de plasma (35), ladite ligne de faisceau (30, 40, 60) comprenant, à l'intérieur d'une chambre à vide (7, 38) :
un système de distribution de faisceau (2, 39) comprenant une lentille de focalisation (8) et des moyens (9, 10, 11, 13, 14, 15) pour refroidir et protéger ladite lentille de focalisation (8) ; lesdits moyens de refroidissement et de protection comprenant des moyens (10, 11) pour guider un gaz de refroidissement (17) vers ladite lentille de focalisation (8), où il impacte la surface externe de ladite lentille (8) et s'échappe vers l'atmosphère ;
un collecteur à miroir EUV (1, 50, 64), qui collecte et focalise l'EUV rayonné dans un faisceau EUV (6, 55, 63, 70) au niveau d'un foyer intermédiaire (IF) ;
un piège de faisceau (3, 42) capable d'amortir au moins une partie du faisceau laser (5, 41) sans imposer d'ombre sur le faisceau EUV collecté et focalisé (6, 55, 63, 70) ; et
un module de foyer intermédiaire (4, 51) pour empêcher des particules et/ou un rayonnement de s'échapper de la chambre à vide (7, 38) avec le faisceau EUV (6, 55, 63, 70).

2. Ligne de faisceau selon la revendication 1, **caractérisée par le fait que** la lentille de focalisation (8) est refroidie par un fluide fourni depuis l'extérieur de la chambre à vide (7).

3. Ligne de faisceau selon la revendication 1 ou 2, **caractérisée par le fait que** la lentille de focalisation (8) est protégé des débris par un gaz éjecté du bord externe de la lentille de focalisation (8) et dirigé le long de la surface interne de la lentille de focalisation (8).

4. Ligne de faisceau selon l'une des revendications 1 à 3, **caractérisée par le fait que** la lentille de focalisation (8) est nettoyée par un gaz éjecté du bord externe de la lentille de focalisation (8) et dirigé le long de la surface interne de la lentille de focalisation (8).

5. Ligne de faisceau selon la revendication 3 ou 4, **caractérisée par le fait que** le gaz éjecté du bord externe de la lentille de focalisation (8) est choisi parmi le groupe comprenant l'hydrogène, l'hélium, l'argon, le néon, le krypton, le xénon, le chlore, le fluor, le brome et l'iode.

6. Ligne de faisceau selon la revendication 5, **caractérisée par le fait que** le gaz est un mélange d'une pluralité de ces gaz, et/ou le gaz est ionisé.

7. Ligne de faisceau selon la revendication 1, **caractérisée par le fait que** le piège de faisceau (3) est refroidi par un fluide, que le fluide de refroidissement passe à travers un canal de refroidissement interne (24) situé dans un boîtier de piège de faisceau (21), et qu'au moins deux tuyaux (18, 19) sont reliés au piège de faisceau (3) pour assurer une entrée et une sortie de flux et maintenir le piège de faisceau (3) en position.

8. Ligne de faisceau selon la revendication 1, **caractérisée par le fait que** des capteurs sensibles au rayonnement et/ou au plasma (25) sont montés sur un côté du piège de faisceau (3) faisant face au plasma, que le piège de faisceau (3) comprend au moins un cône (22, 23) pour recevoir le faisceau laser (5), et que de l'électronique de capteur est stockée et protégée du rayonnement dans un espace de capteur (26) derrière l'au moins un cône (22, 23).

9. Ligne de faisceau selon la revendication 8, **caractérisée par le fait que** les capteurs (25) sont utilisés pour l'alignement, le déclenchement et la surveillance du plasma, du rayonnement et de la turbidité.

10. Ligne de faisceau selon la revendication 8, **caractérisée par le fait que** deux cônes (22, 23) faits de matériaux différents sont situés à l'intérieur du piège de faisceau (3), un premier cône (22) étant fait d'un matériau à haute conductivité thermique, et un second cône (23) étant placé à l'intérieur du premier cône (22) et étant fait d'un matériau ayant un point de fusion élevé.

11. Ligne de faisceau selon la revendication 7, **caractérisée par le fait que** le fluide de refroidissement est choisi parmi un groupe comprenant de l'eau ou de l'huile.

12. Ligne de faisceau selon la revendication 1, **caractérisée par le fait que** le module de foyer intermédiaire (4) est protégé des débris et des particules en suspension par une éjection de gaz.

13. Ligne de faisceau selon la revendication 1, **caractérisée par le fait que** le module de foyer intermédiaire (4) comprend au moins trois sous-chambres (27, 28, 29), que les sous-chambres (27, 28, 29) sont agencées les unes à l'intérieur des autres sous la forme d'une sous-chambre externe (27), d'une sous-chambre intermédiaire (28) et d'une sous-chambre interne (29), et qu'un gaz est éjecté entre la sous-chambre externe (27) et la sous-chambre intermédiaire (28), de telle sorte qu'il circule principalement en direction de la chambre à vide (7).

14. Ligne de faisceau selon la revendication 13, **caractérisée par le fait que** toutes les sous-chambres (27, 28, 29) comprennent un trou central, que le trou de la sous-chambre intermédiaire (28) est plus petit que le trou de la sous-chambre externe (27), et que le trou de la sous-chambre intermédiaire (28) peut être ajusté selon la direction du faisceau EUV (6).

15. Ligne de faisceau selon la revendication 13 ou 14, **caractérisé par le fait que** la pression dans un espace (31) entre la sous-chambre externe (27) et la sous-chambre intermédiaire (28) est supérieure à la pression dans la chambre à vide (7) à l'extérieur du module de foyer intermédiaire (4), et est supérieure à la pression dans l'espace (32) entre la sous-chambre intermédiaire (28) et la sous-chambre interne (29), et à la pression dans une interface (30) à l'intérieur de la sous-chambre interne (29), tandis que la pression dans l'espace (32) entre la sous-chambre interne (29) et la sous-chambre intermédiaire (28) est inférieure à la pression dans l'interface (33) à l'intérieur de la sous-chambre interne (29).

16. Ligne de faisceau selon la revendication 13, **caractérisée par le fait que** la position du module de foyer intermédiaire (4) peut être ajustée afin que le foyer du rayonnement soit centré à l'intérieur des sous-chambres (27, 28, 29).

17. Ligne de faisceau selon la revendication 13, **caractérisée par le fait qu'**un filtre de pureté spectrale (36) est ajouté dans l'interface (37) à l'intérieur de la sous-chambre interne (29), et que le filtre de pureté spectrale (36) est refroidi (37).

18. Ligne de faisceau selon la revendication 13, **caractérisée par le fait que** le gaz est choisi parmi un groupe comprenant l'hydrogène, l'hélium, l'argon, le néon, le krypton, le xénon, le chlore, le fluor, le brome et l'iode.

19. Ligne de faisceau selon la revendication 18, **caractérisée par le fait que** le gaz est un mélange d'une pluralité de ces gaz, et/ou le gaz est ionisé.

20. Ligne de faisceau selon la revendication 1, **caractérisée par le fait que** le collecteur à miroir EUV (50, 64) fait partie d'un système de déviation de faisceau (44) qui comprend au moins un miroir de focalisation (50, 64), qui focalise le rayonnement dévié dans le faisceau EUV (55, 70) au niveau du foyer intermédiaire (IF), et qu'un miroir de déviation plan supplémentaire (49) est prévu, lequel dévie une petite partie du rayonnement EUV généré sur le miroir de focalisation (50).

21. Ligne de faisceau selon la revendication 20, **caractérisée par le fait que** le système de déviation de faisceau (44) est placé dans une enceinte (45, 46, 47 ; 66) qui comprend un orifice d'entrée de faisceau (43, 61) pour le rayonnement EUV entrant et un orifice de sortie de faisceau (48) pour libérer le faisceau EUV focalisé (55, 70) en chemin vers le module de foyer intermédiaire (51), l'enceinte (45, 46, 47) comprend un premier conteneur de miroir (45) enveloppant le premier miroir de déviation (49) et, à distance dudit premier conteneur de miroir (45), un second conteneur de miroir (47) enveloppant le second miroir de focalisation (50), et un tube de raccordement (46) pour relier les deux conteneurs de miroir (45, 47), de telle sorte que le faisceau EUV s'étendant du premier miroir (49) au second miroir (50) et le faisceau EUV focalisé s'étendant du second miroir (50) à l'orifice de sortie de faisceau (48) sont enveloppés par ledit tube de raccordement (46).

22. Ligne de faisceau selon la revendication 21, **caractérisée par le fait que** l'enceinte (45, 46, 47) est montée sur une plaque d'ajustement (57) qui peut être tournée dans un plan parallèle au plan du faisceau EUV dévié (55).

23. Ligne de faisceau selon la revendication 21 ou 22, **caractérisée par le fait que** la pression à l'intérieur de l'enceinte (45, 46, 47) est supérieure à la pression dans la chambre à vide environnante (38), de telle sorte que des débris sont empêchés d'entrer dans l'orifice d'entrée de faisceau (43) de l'enceinte (45, 46, 47).

24. Ligne de faisceau selon l'une des revendications 21 à 23, **caractérisée par le fait que** le faisceau EUV focalisé (55) s'échappe de la chambre à vide (38) dans la direction qui est essentiellement opposée à la direction du faisceau laser entrant (41).

25. Ligne de faisceau selon l'une des revendications 21 à 24, **caractérisée par le fait qu'**une pression supérieure dans l'enceinte (45, 46, 47 ; 66) est obtenue au moyen d'au moins un éjecteur de gaz (67), qui dirige un gaz éjecté (68) sur le miroir (49, 64) faisant face au plasma.

26. Ligne de faisceau selon l'une des revendications 21 à 25, **caractérisée par le fait que** l'enceinte (66) comprend une partie d'entrée de faisceau (61) qui est de préférence échangeable, et dont l'aire de trou et la direction d'éjection de flux peuvent de préférence être modifiées.
